# EUROPÄISCHE PATENTSCHRIFT

(11) **EP 2 961 251 B1**
(45) Veröffentlichungstag und Bekanntmachung des Hinweises auf die Patenterteilung: **13.12.2017**
(21) Anmeldenummer: 15001389.4
(22) Anmeldetag: 08.05.2015
(51) Int. Cl.: H05K 5/04, H05K 7/18, F16B 5/06, H02B 1/01, F16B 5/00

(54) **VERBINDUNGSKONSTRUKTION ZUR VERBINDUNG ANEINANDERSTOSSENDER BLECHTEILE UND DIESE AUFWEISENDES BLECHGEHÄUSE**
CONNECTION STRUCTURE FOR CONNECTING ABUTTING SHEET SECTIONS AND A SHEET METAL CASING WITH SAME
CONSTRUCTION DE LIAISON DE PIÈCES DE TÔLE ADJACENTES ET BOÎTIER EN TÔLE LES COMPRENANT

(30) Priorität: 27.06.2014 DE 202014005166 U
(43) Veröffentlichungstag der Anmeldung: 30.12.2015
(73) Patentinhaber: De Crignis Blechverarbeitung GmbH, 86165 Augsburg (DE)
(72) Erfinder: Scharf, Manfred, 86447 Eisingersdorf/Affing (DE); Kleiner, Herwig, 86199 Augsburg (DE)
(74) Vertreter: Gallo, Wolfgang

(56) Entgegenhaltungen:
- DE-A1- 19 600 126
- JP-A- H10 167 075
- US-A- 3 510 010
- US-A- 4 928 834
- US-A- 5 593 219
- US-A1- 2006 096 939
- US-A1- 2011 155 679
- US-A1- 2013 186 847

## Beschreibung

Die Erfindung betrifft eine Blechkonstruktion mit einer Verbindungsanordnung zur Verbindung aneinanderstoßender Blechteile bei mehrteiligen Blechkonstruktionen, sowie ein eine solche Verbindungskonstruktion aufweisendes Blechgehäuse.

Ein Hauptanwendungsgebiet der Erfindung ist beispielsweise der Gehäusebau, wo aneinanderstoßende Komponenten eines Blechgehäuses miteinander zu verbinden sind.

Bekannte Verbindungskonstruktionen zur Verbindung aneinanderstoßender Blechteile, beispielsweise aneinandergrenzende Gehäuse- oder Schrankwandteile, umfassen Schweißnähte, Punktschweißverbindungen überlappender oder umgebogener und aneinandergestoßener Randstreifen, und Verschrauben oder Vernieten überlappender oder umgebogener und aneinandergestoßener Randstreifen.

Alle diese bekannten und üblichen Verbindungsarten sind relativ fertigungsaufwändig und mit Ausnahme von Schraubverbindungen nicht mehr lösbar. Schweißverbindungen haben zudem den Nachteil, dass sie wegen der Schweißwärme die Gefahr des Verzugs mit sich bringen, und wenn sie im sichtbaren Bereich der Oberfläche beispielsweise einer Blechgehäusewand liegen, stören sie das optische Erscheinungsbild der Oberfläche. Das Dokument JP 10-167075 A zeigt eine Blechkonstruktion, bei dem die vertikalen Ständer einen sich verjüngenden Schlitz aufweisen, in den hakenförmige Vorsprünge der Regalböden eingehängt werden. Aufgabe der Erfindung ist es, eine Verbindungsanordnung zur Verbindung aneinanderstoßender Blechteile oder Blechkomponenten einer Blechkonstruktion zu schaffen, die keine Schweißverbindung erfordert, eine einfache Montage ermöglicht, ein sauberes Erscheinungsbild der Sichtfläche der aneinandergestoßenen Blechteile oder Blechkomponenten ergibt, und bei Bedarf auf einfache Weise wieder lösbar ist.

Diese Aufgabe wird gemäß der Erfindung durch die im Anspruch 1 angegebene Anordnung gelöst. Vorteilhafte Ausgestaltungen der Erfindung sind Gegenstand der Unteransprüche.

Die erfindungsgemäße Blechkonstruktion ergibt außerdem den Vorteil einer besonders großen Steifigkeit und Festigkeit, und sie ermöglicht auf einfache Weise den Bau von Blechgehäusen oder Blechschränken in Modulbauweise, um so aus baukastenartigen Standardelementen beispielsweise Gehäuse unterschiedlicher Breite oder unterschiedlicher Tiefe zusammenbauen zu können.

Mittels der erfindungsgemäßen Blechkonstruktion können also zwei Gehäusehälften, die gleich oder unterschiedlich groß ausgebildet sein können, oder mehrere Gehäusesegmente miteinander verbunden werden. Dabei können die Gehäusehälften oder Gehäusesegmente entlang zweier gegenüberliegender vertikaler Verbindungsstöße mittels der erfindungsgemäßen Verbindungsanordnung verbunden werden, oder die Gehäusehälften oder Gehäusesegmente können entlang nur einer der beiden vertikalen Verbindungslinien mit der erfindungsgemäßen Verbindungsanordnung miteinander verbunden sein und entlang der anderen vertikalen Verbindungslinie durch eine Scharnierverbindung miteinander verbunden sein.

Die erfindungsgemäße Blechkonstruktion bringt weiter den Vorteil, dass der Anwender eines aus derart verbundenen Komponenten bestehenden Gehäuses, das beispielsweise aus einem Rückteil und einem Frontteil, die sich jeweils über einen der Gehäusetiefe erstrecken, oder aus seitwärts aneinandergebauten Gehäusesegmenten besteht, erst beispielsweise das Rückteil an einem Einsatzort montieren, auf einem Sockel verankern, und Einbauten einbauen kann, ohne vom Frontteil an den Montagearbeiten behindert zu werden, und dann auf einfache Weise das Frontteil anbringen und mit Montage und Einbauarbeiten fortfahren zu können.

Ein Ausführungsbeispiel der Erfindung wird nachstehend unter Bezugnahme auf die anliegenden Zeichnungen mehr im einzelnen beschrieben. In den Zeichnungen zeigt:
- Fig. 1: eine schräg von unten gesehene perspektivische Ansicht von zwei noch mit geringem Abstand aneinandergesetzten Gehäusehälften eines Blechgehäuses mit Verbindungsanordnungen nach der Erfindung,
- Fig. 2: eine Ansicht ähnlich Fig. 1, wobei die beiden Gehäusehälften aneinanderstoßen,
- Fig. 3: eine Ansicht der Anordnung nach Fig. 2, allerdings in schräg von oben gesehener Perspektive,
- Fig. 4: eine Ansicht ähnlich Fig. 3, wobei eine Riegelleiste mit dargestellt ist,
- Fig. 5: eine Darstellung ähnlich Fig. 4, wobei die Riegelleiste auf die sichtbare Verbindungsstelle der beiden Gehäusehälften aufgesetzt ist, sich aber noch in der unverriegelten Stellung befindet, und
- Fig. 6: eine Darstellung ähnlich Fig. 5, wobei die Riegelleiste in ihre Riegelstellung verschoben ist und außerdem am Boden des Gehäuses fixiert ist.

Die Zeichnungen zeigen ein schrankartig ausgebildetes Blechgehäuse mit einer Verbindungsanordnung nach der Erfindung. Das in den Zeichnungen dargestellte Blechgehäuse besteht aus einer hinteren Gehäusehälfte 1 und einer vorderen Gehäusehälfte 2 sowie einer Deckwand 3 und einem Boden 4.

Die hintere Gehäusehälfte 1 und die vordere Gehäusehälfte 2 bestehen jeweils aus einem U-förmig gebogenen Wandkörper, der bei der rückwärtigen Gehäusehälfte aus einer Rückwand 11 und Seitenwandabschnitten 12 besteht, und der bei der vorderen Gehäusehälfte 2 aus einer Frontwand 21 und Seitenwandabschnitten 22 besteht.

Die Seitenwandabschnitte haben an ihren freien Enden jeweils einen um 90 Grad einwärts umgebogenen Randstreifen 13 bzw. 23.

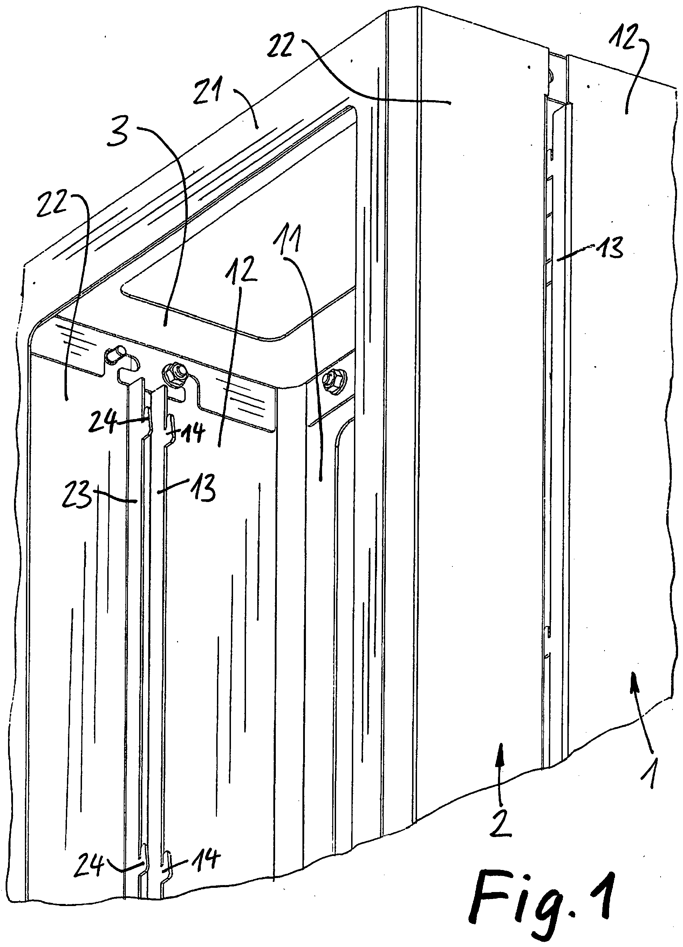

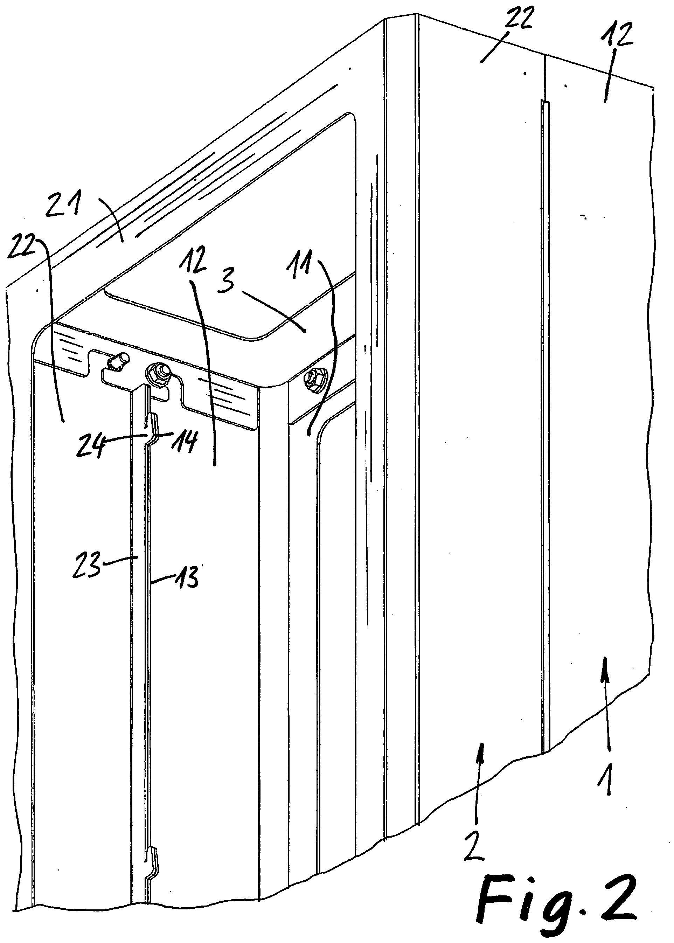

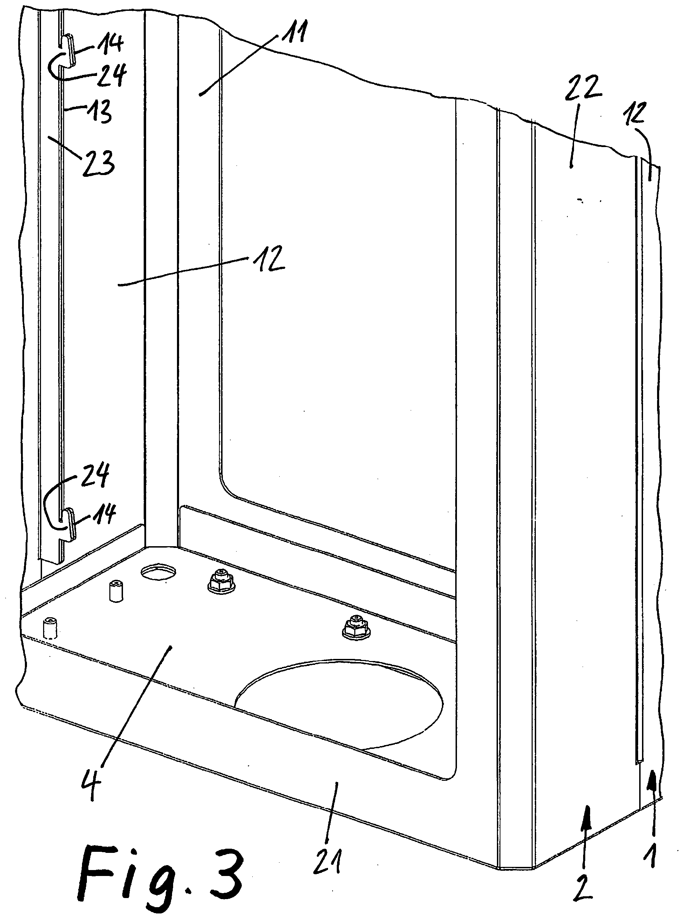

In Fig. 1 sieht man die beiden vorderen und hinteren Gehäusehälften 1, 2 mit ihren jeweiligen Randleisten 13, 23 noch mit geringem Abstand voneinander angeordneten, während in den Fig. 2 und 3 die Gehäusehälften mit ihren Randleisten 13, 23 aneinander anliegend zusammengestoßen sind.

Wie man aus den Zeichnungen außerdem sieht, sind an den Randleisten 13, 23 Hakenelemente 14, 24 angeordnet, die beim Aneinanderstoßen der Gehäusehälften mit den Randleisten 13, 23 aufeinander zu liegen kommen.

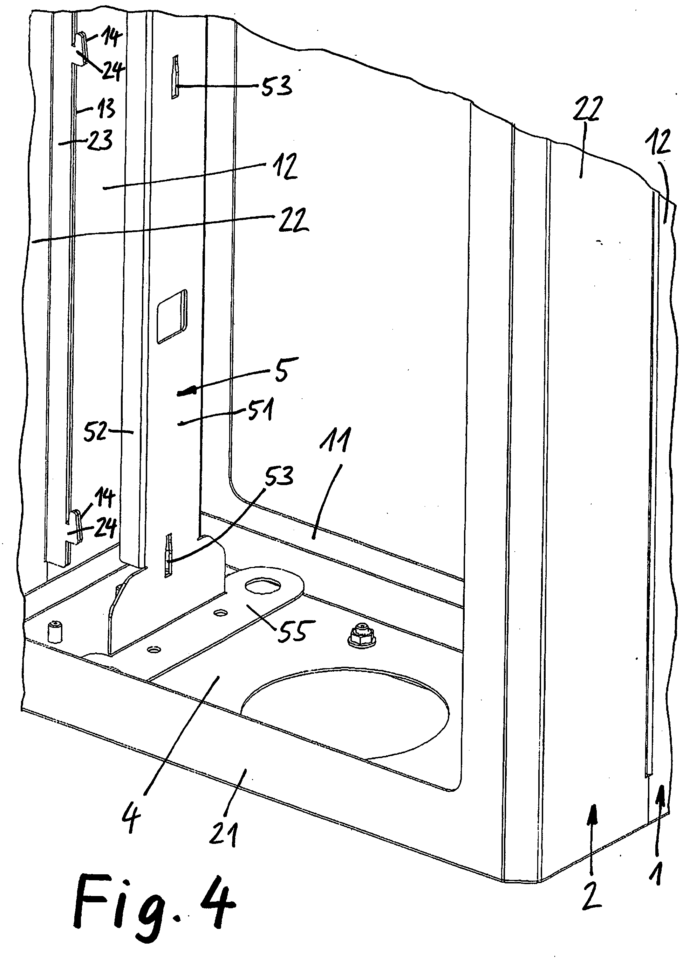

Fig. 4 zeigt die aneinandergesetzten Gehäusehälften in aneinandergestoßenem Zustand, wie auch die Fig. 2 und 3, wobei jedoch nun eine Riegelleiste 5 in das Gehäuse vorderhalb der sichtbaren aneinandergestoßenen Randleisten 13, 23 eingestellt ist. Diese Riegelleiste 5 hat, wie man leicht erkennen kann, wiederum einen U-förmigen Querschnitt mit einer Frontwand 51 und von dieser nach rückwärts gebogenen Seitenwandstreifen 52. Außerdem hat die Riegelleiste Schlitze 53, die so angeordnet, geformt und bemessen sind, dass die Riegelleiste 5 auf die Randleisten 13, 23 aufgesteckt werden kann, wobei sie mit den Schlitzen 53 über die aneinanderstoßenden Hakenelemente 14, 24 gleitet. Die Schlitze 53 der Riegelleiste 5 sind dabei nach oben länger als die Höhe der Hakenelemente 14, 24, und der oberste Bereich der Schlitze 53 hat eine sich nach oben leicht verjüngende Breite.

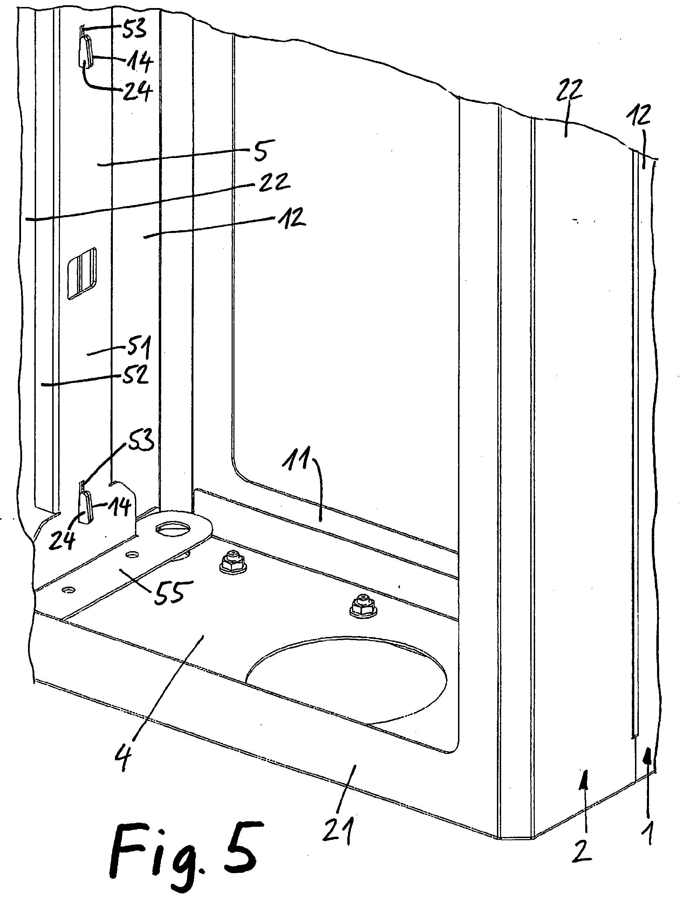

In Fig. 5 sieht man die Riegelleiste auf die Seitenwandabschnitte 12, 22 und die Randleisten 13, 23 aufgesetzt, aber noch nicht in ihrer Verriegelungsposition. Die Seitenwandstreifen 52 der Riegelleiste 5 sind so bemessen, dass sie mit ihren Kantenflächen an den Innenwandflächen der Seitenwandabschnitte 12, 22 anstoßen, wenn sich die Riegelleiste 5 in der in Fig. 5 dargestellten Position befindet, wo ihre Frontfläche sich gerade hinterhalb der aufragenden Hakennasen der Hakenelemente 14, 24 befindet.

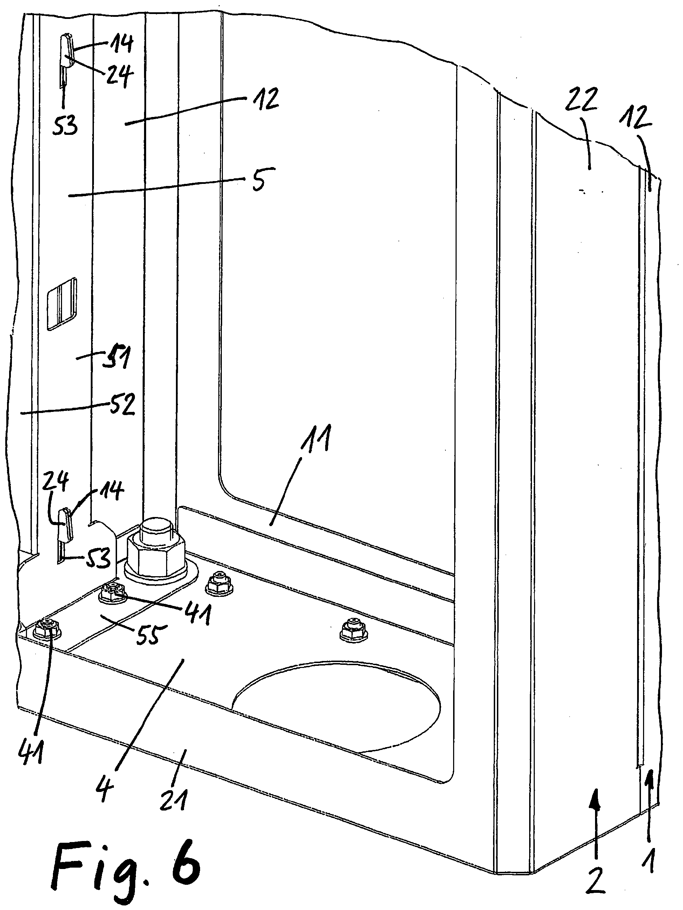

In Fig. 6 ist die Riegelleiste 5 in ihre Verriegelungsposition abgesenkt, wo sie die aufragenden Hakennasen der Hakenelemente 14, 24 hintergreift und, weil im oberen Bereich die Schlitze 53 sich in ihrer Breite konisch etwas verjüngen, außerdem die Randstreifen 13, 23 fest gegeneinander spannt. In dieser Position der Riegelleiste 5 sind also die beiden Gehäusehälften fest miteinander verriegelt. Diese Verriegelung ist jederzeit leicht demontierbar, indem die Riegelleiste 5 wieder nach oben geschoben und abgenommen wird, so dass man das Gehäuse dann wieder öffnen kann.

Wie man weiter in den Fig. 4 bis 6 sieht, hat die Riegelleiste 5 an ihrem unteren Ende einen Fuß 55, mit dem sie in der in die Verriegelungsposition abgesenkten Stellung auf dem Boden 4 aufsteht und an diesem mittels Verschraubungselementen 41 verschraubt ist, so dass ein unbeabsichtigtes Bewegen der Riegelleiste 5 in die Lösestellung nicht möglich ist.

Wie man sieht, bewirkt die Riegelleiste 5 in der dargestellten Konstruktion nicht nur eine feste Verriegelung der miteinander verbundenen Gehäuseteile, sondern darüberhinaus eine erhebliche Versteifung der so verbundenen Gehäusekonstruktion. Die Riegelleiste 5 eignet sich deshalb auch für den Anschluß von zu Gehäuseöffnungen führenden Scharniergelenkarmen, die mit Gehäusetüren verbunden sind.

## Patentansprüche

1. Blechkonstruktion mit einer Verbindungsanordnung zur Verbindung von aneinander stoßenden Blechwandteilen (1,2), wobei die Blechwandteile (1,2) jeweils mit angeformten und jeweils umgebogenen, flächig aneinander liegenden Hakenelementen (14,24) aneinander gestoßen sind, und wobei eine Riegelleiste (5) vorgesehen ist, die Schlitzöffnungen (53) aufweist, welche jeweils ein aneinander gestoßenes Hakenelementpaar (14, 24) der beiden aneinander gestoßenen Blechwandteile (1,2) aufnehmen, und wobei die Riegelleiste (5) zwischen einer Löseposition, in welcher das jeweilige Hakenelementpaar (14, 24) in die Schlitzöffnung (53) hinein oder aus dieser heraus bewegbar ist, und einer Verriegelungsposition längsverschiebbar ist, in welcher die Riegelleiste (5) die aneinander gestoßenen Hakenelemente (14,24) des jeweiligen Hakenelementpaars hintergreift und dadurch die aneinander gestoßenen Blechwandteile (1,2) miteinander verriegelt.

2. Blechkonstruktion nach Anspruch 1, wobei die Hakenelemente (14, 24) an umgebogenen Randstreifen (13,23) jedes Blechwandteils (1, 2) angeformt sind.

3. Blechkonstruktion nach Anspruch 2, wobei die Riegelleiste (5) als im Querschnitt U-förmig ausgebildetes Blechteil (51) mit zu den Blechwandteilen (1, 2) hin umgebogenen und sich darauf abstützenden Schenkeln (52) ausgebildet ist.

4. Blechkonstruktion nach einem der Ansprüche 1 bis 3, wobei die mit der Riegelleiste (5) zusammenwirkenden Kantenflächen der Hakenelemente (14, 24) leicht konisch zur Riegelleiste (5) hin verlaufen, um beim Verschieben der Riegelleiste (5) in die Verriegelungsposition eine Verspannung zu ergeben.

5. Blechkonstruktion nach einem der Ansprüche 1 bis 4, wobei jede Schlitzöffnung (53) entgegen der Richtung der Verschiebebewegung aus der Löseposition in die Verriegelungsposition schwach konisch verengt ist, um bei Bewegung der Riegelleiste (5) aus der Löseposition in die Verriegelungsposition die aneinander gestoßenen Hakenelemente (14,24) jedes Hakenelementpaars zusammen zu spannen.

6. Blechkonstruktion nach einem der Ansprüche 1 bis 5, wobei die Riegelleiste (5) in ihrer Verriegelungsposition fixierbar ist.

7. Blechgehäuse, bestehend aus zwei gleich oder verschieden großen Gehäusehälften oder aus mehreren aneinandergrenzenden Gehäusesegmenten, wobei die Gehäusehälften oder Gehäusesegmente jeweils als Blechkonstruktion mit einer Verbindungsanordnung nach einem der Ansprüche 1 bis 6 miteinander verbunden sind.

8. Blechgehäuse nach Anspruch 7, wobei die beiden Gehäusehälften oder zwei aneinander grenzende Gehäusesegmente längs einer ersten vertikalen Verbindungslinie durch eine Scharnierverbindung miteinander verbunden sind und längs einer gegenüberliegenden zweiten vertikalen Verbindungslinie als Blechkonstruktion mit einer Verbindungsanordnung nach einem der Ansprüche 1 bis 6 miteinander verbunden sind.

9. Blechgehäuse nach Anspruch 7 oder 8, wobei eine Riegelleiste (5) zugleich als Träger zum Anschluss mindestens eines zu einer Gehäuseöffnung hin verlaufenden Türscharnierarms dient.

## Claims

1. A sheet metal structure having a connection arrangement for connecting abutting sheet metal wall parts (1, 2), wherein the sheet metal wall parts (1, 2) are abutting in each case via hook elements (14, 24) that are formed thereon, bent over and lying flat against each other, and wherein a rail bar (5) with slotted openings (53) is provided, the openings respectively receiving a pair of abutting hook elements (14, 24) of the two abutting sheet metal wall parts (1, 2), and wherein the rail bar (5) is movable in the longitudinal direction between a release position, in which the respective pair of hook elements (14, 24) can be moved into or out of the slotted opening (53), and a locked position, in which the rail bar (5) engages the abutting hook elements (14, 24) of the respective pair of hook elements from behind and thereby locks the abutting sheet metal wall parts (1, 2) to each other.

2. The sheet metal structure according to claim 1, wherein the hook elements (14, 24) are formed onto bent-over edge strips (13, 23) of each sheet metal wall part (1, 2).

3. The sheet metal structure according to claim 2, wherein the rail bar (5) is configured as a sheet metal part (51) having a U-shaped cross section, with legs (52) bent towards the sheet metal wall parts (1, 2) and resting thereon.

4. The sheet metal structure according to any one of claims 1 to 3, wherein the edge surfaces of the hook elements (14, 24) that cooperate with the rail bar (5) run with a slight conical tapering towards the rail bar (5) in order to create tension when the rail bar (5) is moved to the locked position.

5. The sheet metal structure according to any one of claims 1 to 4, wherein each slotted opening (53) is narrowing with a slight conical tapering in a direction against the direction of the movement from the release position to the locked position in order to tighten the abutting hook elements (14, 24) of each pair of hook elements together upon movement of the rail bar (5) from the release position to the locked position.

6. The sheet metal structure according to any one of claims 1 to 5, wherein the rail bar (5) can be fixed in its locked position.

7. A sheet metal casing consisting of two casing halves with the same or differing sizes, or of several adjoining casing segments, wherein the casing halves or casing segments are connected to each other as a sheet metal structure by means of a connection arrangement according to any one of claims 1 to 6.

8. The sheet metal casing according to claim 7, wherein the two casing halves or two adjoining casing segments are connected to each other along a first vertical connecting line by means of a hinged connection, and along an opposing second vertical connecting line, are connected to each other as a sheet metal structure by means of a connection arrangement according to any one of claims 1 to 6.

9. The sheet metal casing according to claim 7 or 8, wherein a rail bar (5) at the same time serves as a support for the connection of at least one door hinge arm extending towards an opening of the casing.

## Revendications

1. Construction de tôle avec un arrangement de liaison destiné à relier des pièces de paroi en tôle (1, 2) adjacentes, les pièces de paroi en tôle (1, 2) en chaque cas étant adjacentes avec des éléments d'accrochage (14, 24) qui sont respectivement pliés et disposés à plat l'un contre l'autre, et dans laquelle une bande de verrouillage (5) est prévue, la bande présentant des ouvertures de fente (53) qui respectivement reçoivent une paire d'éléments d'accrochage adjacents (14, 24) des deux pièces de paroi en tôle (1, 2) adjacentes, et dans laquelle la bande de verrouillage (5) est déplaçable, dans la direction longitudinale, entre une position de desserrage, dans laquelle la paire d'éléments d'accrochage (14, 24) respective est déplaçable dans ou hors de l'ouverture de fente (53), et une position de serrage dans laquelle la bande de verrouillage (5) vient en prise de l'arrière avec les éléments d'accrochage (14, 24) adjacents de la paire d'éléments d'accrochage respective, et ainsi verrouille les pièces de paroi en tôle (1, 2) adjacentes.

2. Construction de tôle selon la revendication 1, dans laquelle les éléments d'accrochage (14, 24) sont formés sur une bande marginale pliée (13, 23) de chaque pièce de paroi en tôle (1,2).

3. Construction de tôle selon la revendication 2, dans laquelle la bande de verrouillage (5) est configurée sous forme d'une pièce en tôle (51) avec profil en U, ayant des branches (52) pliées vers les pièces de paroi en tôle (1, 2) et restantes sur ceux-ci.

4. Construction de tôle selon l'une quelconque des revendications 1 à 3, dans laquelle les surfaces des bords des éléments d'accrochage (14, 24) qui interagissent avec la bande de verrouillage (5) sont légèrement coniques vers la bande de verrouillage (5) afin de produire une tension lorsque la bande de verrouillage (5) est déplacée vers la position de verrouillage.

5. Construction de tôle selon l'une quelconque des revendications 1 à 4, dans laquelle chaque ouverture de fente (53) est légèrement conique, opposée à la direction du mouvement de déplacement hors de la position de desserrage vers la position de serrage, afin de serrer ensemble les éléments d'accrochage (14,24) de chaque paire d'éléments d'accrochage lorsque la bande de verrouillage (5) est déplacée hors de la position de desserrage vers la position de serrage.

6. Construction de tôle selon l'une quelconque des revendications 1 à 5, dans laquelle la bande de verrouillage (5) peut être fixée dans sa position de serrage.

7. Boîtier en tôle consistant en deux moitiés du boîtier de dimensions égales ou différentes, ou de plusieurs segments de boîtier adjacents, les moitiés du boîtier ou les segments de boîtier respectivement étant reliés l'un à l'autre en tant que construction de tôle au moyen d'un arrangement de liaison selon l'une quelconque des revendications 1 à 6.

8. Boîtier en tôle selon la revendication 7, dans lequel les deux moitiés du boîtier ou deux segments de boîtier adjacents sont reliés entre eux le long d'une première ligne de liaison verticale au moyen d'une liaison à charnière, et le long une seconde ligne de liaison verticale et opposée, en tant que construction de tôle au moyen d'un arrangement de liaison selon l'une quelconque des revendications 1 à 6.

9. Boîtier selon la revendication 7 ou 8, dans lequel une bande de verrouillage (5) en même temps serve de support pour relier au moins un bras d'une charnière de porte s'étendant vers une ouverture du boîtier.
